Europäisches Patentamt

(19) European Patent Office

Office européen des brevets

(11) Veröffentlichungsnummer: **0 000 114**
**B1**

(12) **EUROPÄISCHE PATENTSCHRIFT**

(21) Anmeldenummer: **78100005.4**

(22) Anmeldetag: **01.06.78**

(51) Int. Cl³: **H 01 L 21/82,**
**H 01 L 27/02,**
**H 01 L 21/316, //**
**H 03 K 19/09**

(54) **Verfahren zum Herstellen einer integrierten logischen Schaltung mit bipolaren Transistoren und integrierte Schaltung hergestellt nach diesem Verfahren**

(30) Priorität: **16.06.77 US 807286**

(43) Veröffentlichungstag der Anmeldung:
**10.01.79 Patentblatt 79/01**

(45) Bekanntmachung des Hinweises auf die Patenterteilung:
**30.04.80 Patentblatt 80/09**

(84) Benannte Vertragsstaaten:
**BE CH DE FR GB NL SE**

(56) Entgegenhaltungen:
**DE - A - 2 455 347**
**FR - A - 2 290 758**
**FR - A - 2 319 197**
**US - 3 966 501**

(73) Patentinhaber: **International Business Machines Corporation**
**Armonk, N.Y. 10504 (US)**

(72) Erfinder: **Bergeron, David L.**
**7606 Wedgewood Drive**
**Manassas, Virginia, 22110 (US)**
**Stephens, Geoffrey B.**
**10 Mercer Court**
**Catlett, Virginia, 22019 (US)**

(74) Vertreter: **Böhmer, Hans Erich, Dipl.-Ing.**
**Schönaicher Strasse 220**
**D - 7030 Böblingen (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Verfahren zum Herstellen einer integrierten logischen Schaltung mit bipolaren Transistoren und integrierte Schaltung hergestellt nach diesem Verfahren

Die Erfindung betrifft ein Verfahren zum gleichzeitigen Herstellen von mit relativ kleinen Spannungen arbeitenden bipolaren Transistoren für integrierte logische Schaltungen und von mit relativ hohen Spannungen arbeitenden Transistoren für integrierte Ausgangs-Treiberstufen auf einem gemeinsamen Halbleiterplättchen, durch Herstellen einer ersten und einer zweiten vergrabenen Zone eines zur Dotierung des Halbleitersubstrats entgegengesetzten zweiten Leitungstyps, Niederschlagen einer epitaxialen Schicht des zweiten Leitungstyps über der ersten und der zweiten vergrabenen Zone und dem Substrat für eine nachfolgende Herstellung einer ersten bzw. zweiten Basiszone in der Epitaxialschicht über der ersten bzw. über der zweiten vergrabenen Zone und die darauf folgende Herstellung einer Kollektorzone des zweiten Leitungstyps in der ersten Basiszone und einer Emitterzone des zweiten Leitungstyps in der zweiten Basiszone.

Integrierte logische I²L-Schaltungen mit Ladungsträgerinjektion arbeiten bei einem relativ niedrigen Signalpegel von 1 Volt. Man hat bisher große Schwierigkeiten dabei gehabt, eine Signalübertragung zwischen verschiedenen I²L-Halbleiterplättchen oder Chips bei diesem niedrigen Signalpegel herzustellen. Zusätzliche Spannungsverstärkerschaltungen benötigen am Eingang/Ausgang des Chips eine höhere Durchbruchsspannung am Basis-Kollektorübergang des in der Chip-Ausgangs-Treiberstufe verwendeten vertikalen bipolaren Transistors. Erhöht man jedoch die Basis-Kollektor-Schichtdicke eines nach unten injizierenden vertikalen bipolaren Transistors für Ausgangs-Treiberstufen, so ergibt sich, daß dann die mit Aufwärtsinjektion arbeitenden vertikalen bipolaren Transistoren der innen liegenden logischen I²L-Schaltungen einen sehr geringen Emitter-Wirkungsgrad und eine sehr große Ladungsspeicherkapazität aufweisen, da beide Arten von Bauelementen in jedem praktisch durchführbaren und wirtschaftlichen Herstellungsverfahren gleichzeitig hergestellt werden müssen.

Eine Lösung für dieses Problem ist in der DE—OS 24 55 347 offenbart. Das bekannte Verfahren der eingangs genannten Art zeichnet sich dadurch aus, daß zur Erzielung einer unterschiedlichen Schichtdicke der Basiszone-Epitaxieschicht zunächst im Analogschaltungsteil und im I²L-Schaltungsteil je eine gesonderte Epitaxieschicht erzeugt, diese im I²L-Schaltungsteil bei maskiertem Analogschaltungsteil sofort wieder entfernt, d. h. abgeätzt wird, worauf erneut im Analogschaltungsteil und im I²L-Schaltungsteil eine zweite Epitaxieschicht erzeugt wird, wodurch die aus zwei Einzelschichten bestehende Epitaxieschicht im Analogschaltungsteil die gewünschte größere Dicke erhält. Dieses Verfahren ist insofern nachteilig, als zwei Epitaxieschichten erzeugt werden müssen und daß ferner eine Epitaxieschicht auf einem Siliciumsubstrat abgeätzt werden muß. Dieses Abätzen von Siliciumschichten auf Silicium ist sehr schwer auf die exakt gewünschte Tiefe präzise einstellbar.

Aus dieser Veröffentlichung ist es ferner bekannt, nur eine einzige Epitaxieschicht mit der größeren der beiden gewünschten Schichtdicken aufzubringen, die dann an der Stelle, an der die Schichtdicke erhalten bleiben soll, mit einer Ätzmaskierungsschicht abgedeckt wird. Anschließend wird der nicht maskierte Teil der Epitaxieschicht auf die gewünschte Schichtdicke abgeätzt. Hier ist die zuvor genannte Schwierigkeit noch ausgeprägter, da dieses Abätzen nur schwer auf die exakt gewünschte Tiefe durchführbar ist.

Aus der US—PS 3 966 501 ist es ferner bekannt, daß man die Reaktionsfähigkeit einer Siliciumschicht für eine nachfolgende Oxidation durch vorherige Bestrahlung mit Ionen erhöht, die schwerer sind als das zu bestrahlende Grundmaterial.

Der Erfindung liegt nun die Aufgabe zugrunde, das aus dem Stande der Technik bekannte Verfahren dahingehend zu verbessern, daß es sich einfacher und mit größerer Genauigkeit durchführen läßt. Dies wird erfindungsgemäß durch folgende Verfahrensschritte erreicht:

Durch Implantation von Ionen in die Oberfläche der über der ersten vergrabenen Zone liegenden epitaxialen Schicht werden in an sich bekannter Weise so starke Schäden in der kristallinen Struktur eines Teils der Schicht erzeugt, daß die Reaktionsfähigkeit in diesem Teil der Schicht für eine nachfolgende Oxidation erhöht wird, während der über der zweiten vergrabenen Zone liegende Teil der Epitaxieschicht durch eine Oxidschicht maskiert ist. Dann wird die gesamte Oberfläche über der ganzen epitaxialen Schicht gleichzeitig einer Oxidationsreaktion ausgesetzt, wodurch in dem mit Ionen implantierten Bereich über der ersten vergrabenen Zone eine relativ dicke Oxidschicht gebildet wird. Anschließend wird in einem Tauchätzverfahren die gesamte Oxidschicht entfernt, wodurch im Bereich der Epitaxialschicht über der ersten vergrabenen Zone eine örtlich verdünnte Epitaxialschicht und über der zweiten vergrabenen Zone eine dickere Epitaxialschicht gebildet wird.

Die Erfindung wird nunmehr anhand von Ausführungsbeispielen in Verbindung mit den beigefügten Zeichnungen im einzelnen beschrieben.

In den Zeichnungen zeigen
Fig. 1A—1I die Folge von Verfahrensschritten in der Bildung eines bipolaren Transi-

stors in einer I²L-Schaltung mit Aufwärtsinjektion und

Fig. 2A—2I die gleichzeitig ablaufende Folge von entsprechenden Verfahrensschritten bei der Bildung eines mit Abwärtsinjektion arbeitenden bipolaren Transistors auf dem gleichen Halbleiterplättchen, welcher für die I²L-Schaltungen dieses Halbleiterplättchens als Ausgangs-Treiberstufe arbeitet.

Beschreibung der bevorzugten Ausführungsformen:

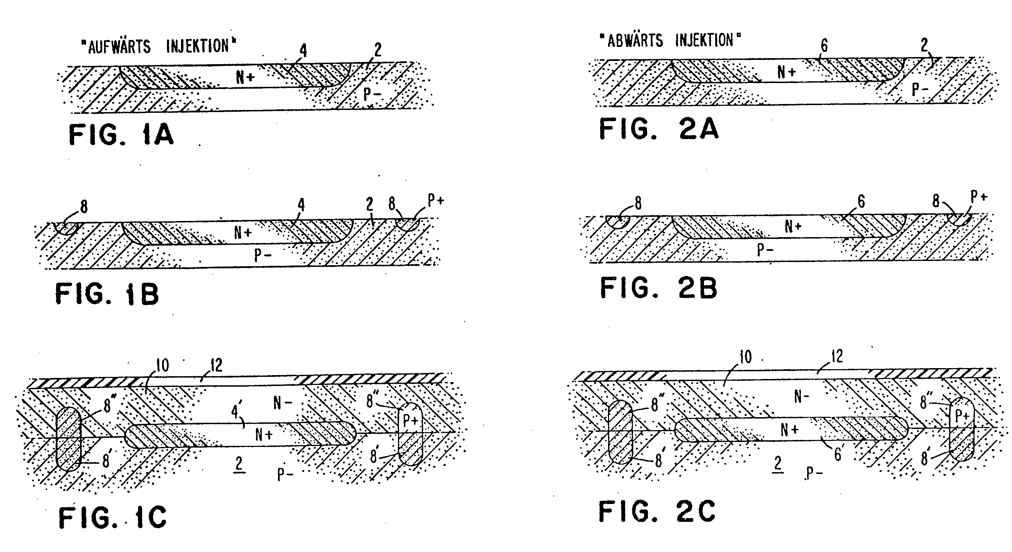

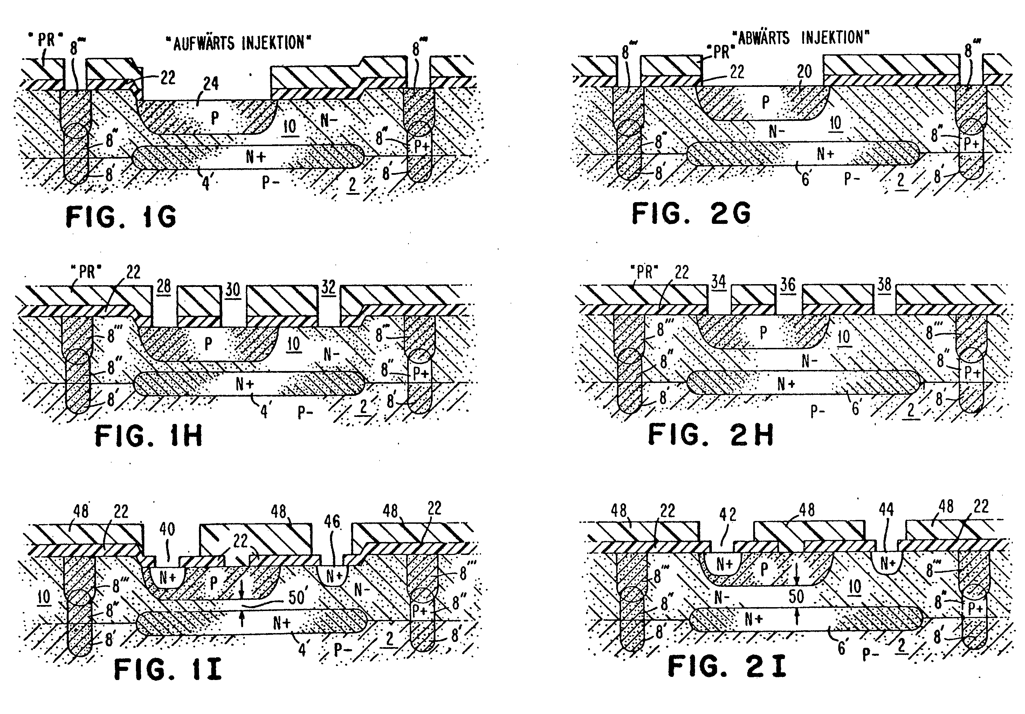

In den Fig. 1A—1I und 2A—2I sind die gleichen Verfahrensschritte bei der Bildung eines aufwärtsinjizierenden und eines abwärtsinjizierenden vertikalen Transistors gezeigt, wobei die gleichen Buchstaben sich auf gleichzeitig ablaufende Verfahrensschritte beziehen.

Fig. 1A und Fig. 2A zeigen die Bildung eines N⁺-leitenden Subemitters 4 und die eines N⁺-leitenden Subkollektors 6 in einem P-leitenden Substrat 2 für den aufwärts injizierenden bzw. abwärts injizierenden Transistor. Die N⁺-Subzonen 4 und 6 werden durch eine übliche Arsendiffusion durch Öffnungen hindurch hergestellt, die durch übliche photolithographische Verfahren in einer auf dem P-leitenden Substrat 2 thermisch aufgewachsenen SiO₂-Maske hergestellt worden sind. Das P-leitende Substrat hat einen spezifischen Widerstand von 5—20 Ohm/cm. Die N⁺-leitenden Zonen 4 und 6 weisen eine Oberflächenkonzentration von mehr als $10^{20}$ je cm³ und eine Schichtdicke von 2,5 $\mu$m auf. Die Zonen 4 und 6 werden vor Bildung der vergrabenen P⁺-leitenden Zonen 8 reoxidiert.

Fig. 1B und 2B zeigen die Bildung von P⁺-leitenden vergrabenen Isolationsbereichen 8 für den aufwärts injizierenden bzw. den abwärts injizierenden Transistor. Die vergrabenen P⁺-leitenden Zonen 8 werden durch übliche Bordiffusion durch Öffnungen hindurch erzeugt, die durch übliche photolithographische Verfahren in einer kummulativen thermisch erzeugten SiO₂-Maskenschicht hergestellt wurden. Die P⁺-leitenden Zonen 8 haben eine Oberflächenkonzentration von mehr als $10^{20}$ cm⁻³ und eine Schichtdicke von 3,0 $\mu$m.

Fig. 1C und 2C zeigen die Bildung einer epitaxialen Schicht 10 für den aufwärts injizierenden bzw. abwärts injizierenden Transistor. Nach Abziehen der zuvor erwähnten Oxidmaskenschicht wird eine N⁻-leitende Schicht 10 epitaxial bis zu einer Dicke von 3,2 $\mu$m und einer Dotierungskonzentration von $2 \times 10^{16}$ je cm³ aufgewachsen. Die vergrabenen Isolationsdiffusionen 8 erweitern sich durch Ausdiffusion in die Teile 8' im Substrat 2 und Teile 8'' in der epitaxialen Schicht 10.

Auf der epitaxialen Schicht 10 wird anschließend eine Siliciumdioxidschicht 12 gebildet. Die Siliciumdioxidschicht 12 wird thermisch in einer O₂H₂O—O₂ Athmosphäre bei 970°C bis auf eine Dicke von 300 nm aufgewachsen.

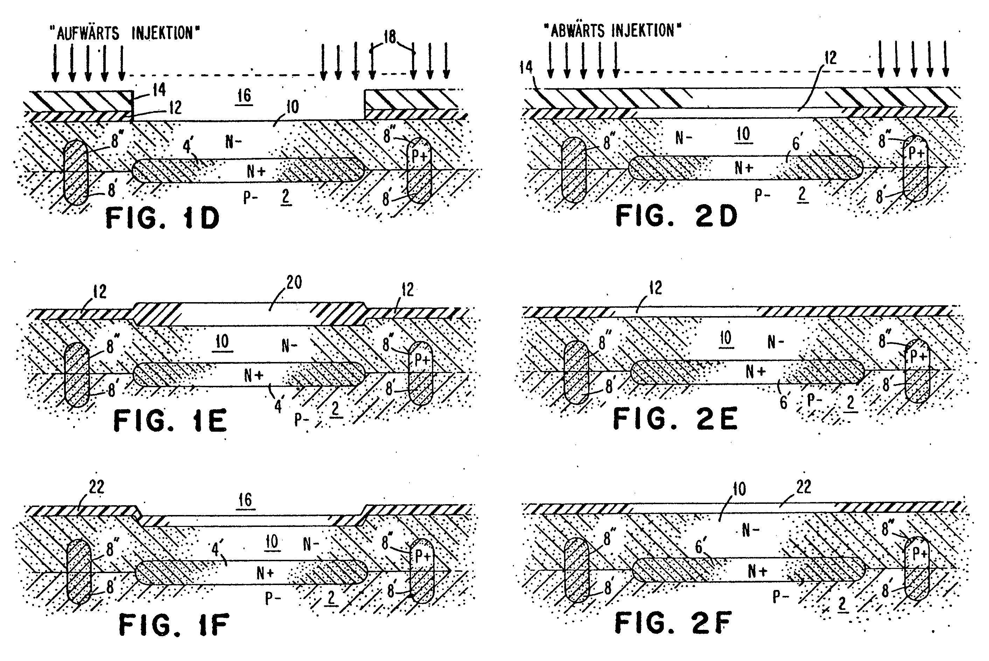

Fig. 1D und 2D zeigen die Bildung einer Photolackschicht 14 über der Siliciumdioxidschicht 12, welche als Maskenschicht für die Ionenimplantation dient. In dem in Fig. 1D gezeigten, in Aufwärtsrichtung injizierenden vertikalen Transistor wird durch die Photolackschicht 14 und die Siliciumdioxidschicht 12 zum Freilegen der Oberfläche der Epitaxialschicht 10 eine Öffnung 16 hergestellt. Bei dem in Fig. 2D dargestellten nach abwärts injizierenden vertikalen Transistor wird keine entsprechende Öffnung hergestellt.

Anschließend folgt ein Verfahrensschritt zum Implantieren von Ionen 18 einer zum Einführen von Schäden in die Kristallstruktur geeigneten Art von Atomen in der innerhalb der Öffnung 16 freiliegenden Zone der epitaxialen Schicht 10. Dafür geeignete Atome sind z. B. H, He, Ne, Ar, Kr, O, Si, C, B und Al. Das Einführen von Schäden in die Kristallstruktur der freiliegenden Zone der epitaxialen Schicht 10 soll dabei die reaktive Oxidationsgeschwindigkeit der Oberfläche und den Prozentsatz des während eines nachfolgenden Oxidationsverfahrensschritts verbrauchten Si erhöhen. Die Implantation wird mit einer üblichen Ionenimplantationsvorrichtung durchgeführt, deren Beschleunigungsspannung im Bereich zwischen 10 und 400 KeV liegt.

Die Photolackschicht 14 und die Siliciumdioxidschicht 12 sind so dick gewählt, daß das Durchdringen des Ionenstrahls 18 in den Bereichen der epitaxialen Schicht 10 abgedeckt wird, die nicht durch eine Öffnung 16 freigelegt sind. Mögliche Dicken der Photolackschicht, der Siliciumdioxidschicht, die Art der implantierten Ionen und die Beschleunigungsspannung sind in Tabelle 1 zusammengestellt.

Tabelle 1

| Dicke der Photolack- schicht (14) | Dicke der Siliciumdioxid- schicht (12) vor und nach Bilden der Schicht (20) | Ionen Art | Ionen Dosierung | Beschleu- nigungs- spannung | Dicke der Si-Oxidschicht (20) |
|---|---|---|---|---|---|
| 2 $\mu$m | 300/320 nm | O | $10^{14}$ | 50 KeV | 200 nm |
| 2 $\mu$m | 300/390 nm | O | $10^{14}$ | 150 KeV | 500 nm |
| 2 $\mu$m | 300/320 nm | Ar | $10^{14}$ | 140 KeV | 200 nm |
| 2 $\mu$m | 300/390 nm | Ar | $10^{14}$ | 300 KeV | 500 nm |
| 2 $\mu$m | 300/320 nm | Si | $10^{14}$ | 70 KeV | 200 nm |
| 2 $\mu$m | 300/390 nm | Si | $10^{14}$ | 200 KeV | 500 nm |

Fign. 1E und 2E zeigen die Bidlung einer Siliciumdioxidschicht 20 nach Entfernen der Photolackmaske 14. Man sieht, daß die Eindringtiefe der Siliciumdioxidschicht 20 größer ist als jede Zunahme der Dicke der bereits bestehenden Siliciumdioxidschicht 12, da die in der Epitaxialschicht 10 durch die Ionenimplantation mit den Ionen 18 eingeführten Schäden an der Kristallstruktur die Reaktionsfähigkeit der so frei liegenden Epitaxialschicht 10 bei der Oxidationsreaktion erhöht haben. Diese thermische Oxidation wird bei 970°C in einer $H_2O$—$O_2$ Atmosphäre mit einer derart bestimmten Zykluszeit durchgeführt, daß die unterhalb der Öffnung 16 liegende, in ihrer Kristallstruktur beschädigte Zone in der Siliciumschicht 10 durchoxidiert wird. Tabelle 1 gibt dabei Schichtdicken für thermisch gewachsene Siliciumdioxidzonen 20 für Dampfzyklen an, die so bestimmt worden sind, daß sich im Vergleich mit dem unbeschädigten Teil der Siliciumschicht 10 eine dreifach so hohe Oxidationsgeschwindigkeit ergibt. Merkliche Strahlungsschäden liegen dabei innerhalb dem Zweifachen der Normalabweichung von dem Maximalwert der Verteilung der implantierten Ionen.

Fign. 1F und 2F zeigen die Bildung der reoxidierten Schicht 22 aus Siliciumdioxid für aufwärts bzw. abwärts injizierende Transistoren nach Entfernen der bestehenden Oxidschicht 12 und der Oxidschicht 20 durch Abziehen der Oxide. Die Oxidschicht 12 und die Oxidschicht 20 werden dabei chemisch durch Ätzen mit Flußsäure entfernt. Die neue Oxidschicht 22 wird in einer $O_2$—$H_2O$—$O_2$ Atmosphäre bei 970°C mit einer solchen Zykluszeit gebildet, daß dabei eine Schichtdicke von 300 nm erreicht wird.

Es wird zu diesem Zeitpunkt darauf hingewiesen, daß die Dicke der Epitaxialschicht 10' des aufwärts injizierenden Transistors oberhalb der Subemitters 4', wo die Oxidschicht 20 gebildet worden war, geringer ist, als die der entsprechenden Epitaxialschicht 10 über dem Subkollektor 6' des nach unten injizierenden Transistors. Beispielsweise weist die Epitaxialschicht 10' eine Dicke von etwa 2,8 $\mu$m, entsprechend einer Dicke von 200 nm zur thermisch gewachsenen Oxidschicht 20 auf, während die Epitaxialschicht 10 eine Dicke von 2,89 um aufweist. In einem anderen Beispiel hat die Epitaxialschicht 10' eine Dicke von etwa 2,65 $\mu$m entsprechend einer Dicke von 500 nm für die thermisch gewachsene Oxidschicht 20 während die Epitaxialschicht 10 eine Dicke von 2,85 $\mu$m aufweist.

In Fign. 1G und 2G ist die Bildung von P-leitenden Basiszonen 24 bzw. 26 für den aufwärts bzw. abwärts injizierenden Transistor dargestellt. Bei diesem Verfahrensschritt wird außerdem die P-leitende nach unten gerichtete Zone 8''' gebildet. Die P-leitenden Zonen 24, 26 und 8''' werden durch übliche photolitographische Verfahren und Diffusion hergestellt. Die P-leitenden Zonen 24, 26 und 8''' haben eine Oberflächenkonzentration von etwa 5 × $10^{18}$ Atomen/$cm^3$ und eine Schichtdicke von etwa 1,2 $\mu$m. Die P-leitenden Zonen 24, 26 und 8''' werden dann in $O_2$ bei etwa 1000°C zur Bildung einer etwa 110 nm starken Oxidschicht oxidiert.

Fign. 1H und 2H zeigen die Bildung von Kontaktbohrungen 34 und 28 durch die Oxidschicht 22 hindurch zur Erzeugung von Emitter und Kollektordiffusionsbereichen 42 bzw. 40 in dem nach unten bzw. nach oben injizierenden Transistor. Die Öffnungen 28, 30, 32, 34, 36 und 38 in der passivierenden Oxidschicht 22 werden gleichzeitig durch übliche photographische und Oxidätzverfahren gebildet.

Fign. 1I und 2I zeigen die fertigen aufwärts bzw. abwärts injizierenden Transistoren. Im aufwärts injizierenden Transistor in Fig. 1I ist ein $N^+$-leitender Kollektor 40 gebildet, während in dem abwärts injizierenden Transistor in Fig. 2I ein N$^+$-leitender Emitter 42 gebildet ist. Die N$^+$-leitenden Zonen 40, 42, 44 and 46 werden dadurch hergestellt, daß zunächst eine Photolacksperrschicht 48 aufgebracht wird, deren Öffnungen die zuvor definierten Oxidöffnungen 28, 32, 34 und 38 überlappen, während die Öffnungen 30 und 36 blockiert werden. Die N$^+$-leitenden Zonen 40, 42, 44 und 46 werden durch Ionenimplantation von Arsen-Ionen durch die Oxidöffnungen 28, 32, 34 und 38 bei einer Energie von 50 KeV und einer Dosierung von 8 × 10$^{15}$ cm$^{-2}$ erzeugt. Die Photolackschicht 48 wird dann abgelöst und bei einem anschließenden Anlassen für 50 Minuten bei 1050°C wird das Arsen aktiviert und diffundiert dann zur gewünschten Funktionstiefe von 0,6 um.

Die Folge von Verfahrensschritten gemäß Fign. 1A bis 1I und 2A bis 2I sind für ein Verfahren bestimmt, das auf einem einzigen Halbleiterschaltungsplättchen durchgeführt wird, wobei mit kleiner Signalspannung arbeitende I$^2$L-Schaltungen und mit relativ hohen Signalspannungen arbeitende Ausgangs-Treiberstufen gebildet werden. Der mit Aufwärtsinjektion betriebene NPN-Transistor gemäß Fig. 1I wird normalerweise in I$^2$L-Schaltungen benutzt und wird mit einer dünnen Epitaxialschicht 50′ zwischen dem vergrabenen Subemitter 4′ und der Basiszone 24 gebildet, während eine dickere Epitaxialschicht 50 den vergrabenen Subkollektor 6′ von der Basiszone 26 des nach unten injizierenden vertikalen NPN-Transistors in Fig. 2I trennt. Durch Verringerung der Dicke der epitaxialen Schicht eines aufwärts injizierenden vertikalen Transistors in einer I$^2$L-Schaltung werden die Ladungsspeichereigenschaften des Bauelements herabgesetzt und der Injektionswirkungsgrad des Bauelementes wird verbessert. Es kann gezeigt werden, daß die in den Epitaxialzonen 50′, 50 gespeicherte Ladung proportional dem Quadrat der Dicke dieser Zonen ist. Das heißt aber, daß für eine thermisch gewachsene Oxidschicht 20 mit einer Dicke von 500 nm und mit einer Aufwärtsdiffusion des Subemitters 4′ von 1,4 μm die gespeicherte Ladung in der Zone 50′ mit einer Dicke von 50 nm rund 25 mal kliener ist als die in der Zone 50 mit einer Dicke von 250 nm gespeicherte Ladung. Es kann gezeigt werden, daß ein aufwärts injizierender Transistor einen Injektionswirkungsgrad aufweist, der proportional der durchschnittlichen Dotierungskonzentration in der Subemitterzone 4′ und 50′ ist. Da die epitaxiale Schicht 50′ niedrig dotiert ist, wird die durchschnittliche Dotierungskonzentration in der Subemitterzone 4′ und 50′ dadurch erhöht, daß man die Dicke der niedrig dotierten Schicht 50′ klein hält.

Durch Erhöhung der epitaxialen Schichtdicke des für Ausgangs-Treiberstufen und Empfangsstufen benutzten abwärts injizierenden vertikalen Transistors kann eine höhere Signalspannung verwendet werden. Es kann gezeigt werden, daß die Durchschlagsspannungen von Kollektor nach Basis und von Kollektor nach Emitter direkt proportional der Dicke der gering dotierten epitaxialen Schicht 50 sind.

### Patentansprüche

1. Verfahren zum gleichzeitigen Herstellen von mit relativ kleinen Spannungen arbeitenden bipolaren Transistoren für integrierte logische Schaltungen und von mit relativ hohen Spannungen arbeitenden Transistoren für integrierte Ausgangs-Treiberstufen auf einem gemeinsamen Halbleiterplättchen, durch Herstellen einer ersten und einer zweiten vergrabenen Zone (4 bzw. 6) eines zur Dotierung des Halbleitersubstrats (2) entgegengesetzten zweiten Leitungstyps (N$^+$),

Niederschlagen einer epitaxialen Schicht (10) des zweiten Leitungstyps über der ersten und der zweiten vergrabenen Zone und dem Substrat für eine nachfolgende Herstellung einer ersten bzw. zweiten Basiszone in der Epitaxialschicht über der ersten bzw. über der zweiten vergrabenen Zone und die darauf folgende Herstellung einer Kollektorzone des zweiten Leitungstyps in der ersten Basiszone und einer Emitterzone des zweiten Leitungstyps in der zweiten Basiszone, dadurch gekennzeichnet,

daß durch Implantation von Ionen nur in die Oberfläche der über der ersten vergrabenen Zone (4) liegenden epitaxialen Schicht (10) in an sich bekannter Weise so starke Schäden in der kristallinen Struktur eines Teils der Schicht erzeugt werden, daß die Reaktionsfähigkeit dieses Teils der Schicht für eine nachfolgende Oxidationsreaktion erhöht wird, während der über der zweiten vergrabenen Zone (6) liegende Teil der Epitaxieschicht (10) durch eine Oxidschicht (12) maskiert ist, und daß dann die gesamte Oberfläche über der ganzen epitaxialen Schicht gleichzeitig einer Oxidationsreaktion ausgesetzt wird, wodurch in dem mit Ionen implantierten Bereich über der ersten vergrabenen Zone (4) eine relativ dicke Oxidschicht (20) gebildet wird, wonach in einem Tauchätzverfahren die gesamte Oxidschicht entfernt wird, wodurch im Bereich der Epitaxialschicht über der ersten vergrabenen Zone (4) eine örtlich verdünnte Epitaxialschicht und über der zweiten vergrabenen Zone (6) ein Bereich einer dickeren Epitaxialschicht gebildet wird.

2. Verfahren nach Anspruch 1, dadurch gekennzeichnet, daß die Ionenimplantation bei einer Beschleunigungsspannung von 10 bis 500 kV bei einer Dosierung von 10$^{12}$—10$^{16}$ Ionen/cm$^3$ Ionen unter Verwendung von H, He, Ne, Kr, Ar, O, Si, C, B oder Al-Ionen durchgeführt wird.

### Claims

1. Method of simultaneously producing on a common semiconductor chip bipolar transistors, operating at relatively low voltages, for integrated logic circuits and transistors, operating at relatively high voltages, for integrated output driver stages,

by producing a first and a second buried zone (4 and 6 respectively) of a second conductivity type (N$^+$) opposite to that used to dope the semiconductor substrate (2),

by depositing an epitaxial layer (10) of the second conductivity type over the first and the second buried zone and the substrate for the subsequent production of a first and a second base zone, respectively, in the epitaxial layer over the first and the second buried zone, respectively, and by subsequently producing a collector zone of the second conductivity type in the first base zone and an emitter zone of the second conductivity type in the second base zone, characterized in that ions are implanted in a manner known per se only into the surface of the epitaxial layer (10) over the first buried zone (4), thus inducing in part of said layer crystalline damage sufficient to enhance its reactivity to a subsequent oxidation reaction, while the part of said epitaxial layer (10) over the second buried zone (6) is masked by an oxide layer (12), and that the surface over the epitaxial layer is simultaneously exposed to an oxidation reaction, causing a relatively thick oxide layer (20) to be formed in the ion implanted region over the first buried layer (4), the whole oxide layer being subsequently stripped by dip etching, causing a locally thinned epitaxial layer to be formed in the region of the epitaxial layer over the first buried zone (4) and a region of a thicker epitaxial layer to be formed over the second buried zone (6).

2. Method in accordance with claim 1, characterized in that ion implantation is effected at an acceleration voltage of between 10 and 500 kv at a dose of $10^{12}$—$10^{16}$ ions/cm$^2$, using H, He, Ne, Kr, Ar, O, Si, C, B or Al ions.

**Revendications**

1. Procédé pour produire simultanément sur une microplaquette à semi-conducteur, des transistors bipolaires, qui fonctionnent à des tensions relativement faibles, pour des circuits logiques intégrés, et des transistors, qui fonctionnent à des tensions relativement élevées, pour des étages de commande de sortie intégrés,

en produisant une première zone (4) et une seconde zone (6) enterrées d'un second type de conductivité (N$^+$) opposé à celui utilisé pour doper le substrat semi-conducteur (2),

en déposant une couche épitaxiale (10) du second type de conductivité sur les première et seconde zones enterrées et le substrat, pour la production subséquente d'une première et d'une seconde zones de base dans la couche épitaxiale sur respectivement les première et seconde zones enterrées, et en produisant ensuite une zone de collecteur du second type de conductivité dans la première zone de base et une zone d'émetteur de second type de conductivité dans la second zone de base, procédé caractérisé en ce que des ions sont implantés d'une façon bien connue uniquement dans la surface de la couche épitaxiale (10) sur la première zone enterée (4), induisant ainsi dans une partie de ladite couche un endommagement cristallin suffisant pour enrichir sa réactivité dans une réaction d'oxydation, tandis que la partie de ladite couche épitaxiale (10) sur la seconde zone enterrée (6) est masquée par une couche d'oxyde (12), et que la surface sur la couche épitaxiale est simultanément exposée à une réaction d'oxydation, ce qui provoque la formation d'une couche d'oxyde relativement épaisse (20) dans la région d'implantation ionique sur la première couche enterrée (4), toute la couche d'oxyde étant ensuite supprimée par un procédé d'attaque par immersion, ce qui provoque la formation d'une couche épitaxiale localement mince dans la région de la couche épitaxiale sur la première zone enterrée (4) et d'une région épitaxiale plus épaisse sur la seconde zone enterrée (6).

2. Procédé selon la revendication 1, caractérisé en ce que l'implantation ionique se fait à une tension d'accélération entre 10 et 500 kv à une dose de $10^{12}$—$10^{16}$ ions/cm$^2$, en utilisant des ions H, He, Ne, Kr, Ar, O, Si, C, B ou Al.

4   2

N+

P—

## FIG. 1A

6   2

N+

P—

## FIG. 2A

8                    4      2  8   P+

N+

P—

## FIG. 1B

8                    6      8   P+

N+

P—

## FIG. 2B

10   12

8"                         N—

4'      N+

8"        P+

8'                    2   P—      8'

## FIG. 1C

10   12

8"                         N—

N+

8"        P+

8'              2   P—   6'      8'

## FIG. 2C

0 000 114

0 000 114

"AUFWÄRTS INJEKTION"

18

14
16
12
10

8"
4'    N-
8'    N+
P-    2

**FIG. 1D**

"ABWÄRTS INJEKTION"

14
12

8"    N-    10    6'    8"
N+
8'    P-    2    8'

**FIG. 2D**

12    20    12

8"    10    N-    8"
8'    N+    P+
4'    P-    2    8'

**FIG. 1E**

12

8"    10    N-    8"
N+    P+
8'    6'    P-    2    8'

**FIG. 2E**

22    16

8"    4'    10    N-    8"
N+    P+
8'    P-    2    8'

**FIG. 1F**

10    22

8"    N-    8"
6'
8'    N+    P+
P-    2    8'

**FIG. 2F**

**"PR"** 8‴ "AUFWÄRTS INJEKTION" 8‴

22 24

P 10 N−

8″ P+

8′ 8‴ 8″

N+

4′ P− 2

**FIG. 1G**

**"PR"** 22

28 30 32

8‴ P 10 N−

8″ 8‴

8′ N+ 8″

4′ P− 2 8′

**FIG. 1H**

48 22 40 48 22 46 48 22

22

8‴ N+ P 10 N−

8″ 50′

8′ N+ 8″

10 4′ P− 2 8′

**FIG. 1I**

8‴ "PR" "ABWÄRTS INJEKTION" 8‴

22 20

P 10

8″ N− 8‴

8′ N+ 8″

6′ P− 2 8′

**FIG. 2G**

**"PR"** 22 34 36 38

8‴ P 10

8″ N−

8′ N+ 8″

P− 6′ 2 8′

**FIG. 2H**

48 22 42 48 44 48 22

N+ P

8‴ N+ 10 8‴

8″ N− 50 8″

8′ N+ 6′ P− 2 8′ P+

**FIG. 2I**